(19) **Europäisches Patentamt**
**European Patent Office**
**Office européen des brevets**

(11) **EP 2 851 450 B1**

(12) **EUROPEAN PATENT SPECIFICATION**

(45) Date of publication and mention
of the grant of the patent:
**03.02.2016 Bulletin 2016/05**

(51) Int Cl.:
*C23C 14/02* *(2006.01)*       *B23P 6/00* *(2006.01)*
*C23C 14/06* *(2006.01)*       *C23C 14/34* *(2006.01)*
*C23C 14/58* *(2006.01)*

(21) Application number: **13185129.7**

(22) Date of filing: **19.09.2013**

(54) **A method for renovation of steel precision pair parts**

Verfahren zur Renovierung von Stahlpaarstücken

méthode de réparation de paires d'éléments en acier

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**25.03.2015 Bulletin 2015/13**

(73) Proprietor: **Rigas Tehniska universitate**
**Riga 1658 (LV)**

(72) Inventors:
• **Urbahs, Aleksandrs**
  **LV-1029 Riga (LV)**
• **Savkovs, Konstantins**
  **LV-1001 Riga (LV)**
• **Urbaha, Margarita**
  **LV-1029 Riga (LV)**
• **Nesterovskis, Vladislavs**
  **LV-2010 Jurmala (LV)**
• **Carjova, Kristine**
  **LV-1055 Riga (LV)**
• **Urbaha, Jeiena**
  **LV-1029 Riga (LV)**
• **Kulesovs, Nikolajs**
  **LV-1021 Riga (LV)**

(74) Representative: **Vitina, Maruta et al**
**Agency TRIA ROBIT**
**P.O. Box 22**
**1010 Riga (LV)**

(56) References cited:
**LV-B- 14 057      US-B1- 6 344 411**

**Description**

The invention pertains to mechanical engineering and may be applied in renovating and repairing steel precision pair (which are pairings of a cylindrical internal part with a matching external part) parts of vehicles, hydraulic and fuel devices, cargo handling equipment, multipliers, etc.

A method of renovating precision pairs for high-pressure fuel pumps is known [patent RU2242523 "Method for renovating of high-curvature cylindrical surfaces of body steel parts"] which involves annealing the plunger at a temperature of 830-850 °C to increase the dimensions of the worn part and treating its steel surface with nitrogen.

The disadvantage of this method is such annealing of the parts, as a result of which the material's plastic deformation and the properties obtained by the precedent thermal processing are lost. Furthermore a significant number of damaged plungers is required, as it is necessary to select a matching pair before renovation.

A method for improving the operational surface of precision pairs is known [patent CN101413106 "Surface modification method for GCr15 plunger matching parts by injecting nitrogen and carbon plasma ions", Xinxin Ma, Guangze Tang] which involves treating the surface with nitrogen and carbon, thereby increasing the wear resistance of alloyed steels and subsequently also its efficiency.

However this method is unsuitable for renovating used and worn precision pairs, as it is not aimed at restoring the original dimensions of precision pair parts, but only improves their wear resistance.

The closest prior art is a method of renovating stainless steel precision pair parts by sputtering wear-resistant coating [patent LV14057 "Method of applying multi-layer wear-resistant coating for precision pair parts"], which involves sputtering a two-layer coating, based on nitrides, oxides, metal carbides and other elements or their conglomerates, on the internal part of the precision pair by means of vacuum ion plasma deposition, whereby the internal layer of variable thickness and microhardness up to 10000 MPa is applied to restore the original dimensions of the part, and the external layer with microhardness exceeding 10000 MPa is wear-resistant.

However the known method fails to provide sufficient dimensional precision of the renovated internal part of the stainless precision pair, as during the sputtering process the internal part of the precision pair heats up to 400-450 °C, as a result of which the martensite structure in the stainless steel begins to decay and the diameter of the internal part of the precision pair decreases, whereas the amount of decrease cannot be predicted beforehand.

The technical problem solved by the present invention is increasing the dimensional precision of the renovated inner part of the precision pair.

In the method for renovating steel precision pair parts which involves measuring the diameter of the internal part of the precision pair, measuring the inner diameter of the external part of the precision pair, determining the thickness of the wear-resistant two-layer coating to be sputtered on the internal part of the precision pair according to the difference between the measured diameters, sputtering the size-restoring layer of aluminium and titanium alloy with microhardness up to 10000 MPa on the internal part of the precision pair by means of ion plasma deposition, sputtering the outer wear-resistant layer of aluminium and titanium alloy nitride with microhardness exceeding 10000 MPa on the internal part of the precision pair by means of ion plasma deposition, and measuring the diameter of the renovated internal part of the precision pair, according to the invention, before measuring the diameter of the internal part of the precision pair, the internal part of the precision pair is thermally annealed at a temperature of 400-600 °C and the oxidised layer is mechanically removed from the surface of the internal part of the precision pair. Thermal annealing of the internal part of the steel precision pair at a temperature of 400-600 °C ensures that, during annealing, the specific part of steel's martensite structure is decayed that would affect the decrease of the diameter of the internal part of the precision pair during the process of sputtering the wear-resistant two-layer coating. The annealing temperature must not exceed 600 °C, as at higher temperatures an excessively thick oxide layer is formed on the part's surface significantly reducing its quality, whereby the part loses its mechanical durability and becomes too soft.

The preferable layer thickness of the wear-resistant two-layer coating to be sputtered is as follows: the thickness of the outer wear-resistant layer of titanium and aluminium alloy nitride with microhardness exceeding 10000 MPa is 2-5 μm, whereas the thickness of the size-restoring layer of titanium and aluminium alloy with microhardness up to 10000 MPa is such that it compensates the remaining wear of the internal part of the precision pair. If the thickness of the outer wear-resistant layer of titanium and aluminium alloy nitride with microhardness exceeding 10000 MPa is less than 2 μm, it may become damaged when fitted by grinding, as the layer is very thin. If the thickness of the layer exceeds 5 μm, the inner pressures may be excessive and damage the coating or even the entire part.

The present method is implemented in the following way.

As an example of implementing the present invention the technological process of renovating a precision pair used in the hydro fuel equipment of a locomotive diesel engine's high pressure pump is described. The precision pair comprises a shell as the external part of the precision pair and a plunger as the internal part of the precision pair. The part to be renovated is the internal component of the pair, i.e. the plunger, which under regular usage conditions develops an even wear along the entire diameter. The plunger material is steel XBr-LU (high-strength low-alloy tool steel) consisting of: Fe as the basic element, 0.90-1.05% C, 0.90-1.20% Cr, 1.20-1.60% W, 0.80%-1.10% Mn, technological additions.

The initial hardness of the plunger material after ageing is 60-63 HRC.

The diameter of the worn plunger $d_w$=17.005 mm is measured (the measurement is optional). The plunger is thermally annealed at the temperature of 500 °C and held for 15 minutes from the moment the annealing temperature is reached. The oxide layer is mechanically removed from the plunger surface by using fine sandpaper. The diameter of the plunger $d_0$=16.988 mm and the inner diameter of the shell $D_w$=17.014 mm is measured. The thickness of the wear-resistant two-layer coating h must be equal to one half of the difference between the diameter of the plunger and the inner diameter of the shell. To the precision pair in question

$$h = (D_w - d_0)/2 = (17.014 \text{ mm} - 16.988 \text{ mm})/2 = 0.013 \text{ mm} = 13 \text{ } \mu\text{m}.$$

The thickness of the outer wear-resistant layer of titanium and aluminium alloy nitride is set to $h_2$ = 5 $\mu$m. The thickness of the size-restoring layer of aluminium and titanium alloy must be such to compensate the remaining wear of the internal part of the precision pair, i.e.

$$h_1 = h - h_2 = 13 \text{ } \mu\text{m} - 5 \text{ } \mu\text{m} = 8\mu\text{m}.$$

The calculated thickness of the layer $h_1$ is increased by 1 $\mu$m to provide for fitting the precision pair by grinding, thus the thickness of the size-restoring layer of aluminium and titanium alloy to be sputtered amounts to 9 $\mu$m.

The wear-resistant two-layer. coating is sputtered on the plunger by means of ion plasma deposition with a modernized appliance HHB-6,6-И1, using titanium and aluminium cathodes, as well as an aluminium target on magnetron. Before placing the plunger in the vacuum chamber it is degreased. The size-restoring layer, consisting of aluminium and titanium alloy, is sputtered with the following settings: $P_{Ar}$=1-5·10"³ mmHg; $U_p$=800 V; $I_{Ti}$=60 A; $I_{Al}$=70 A; $I_{mag·Al}$=7 A; $U_{mag·Al}$=400 V; which ensure that the layer is formed at the rate of 8 $\mu$m per hour, and the duration of the sputtering is 1.125 hours. The thickness of the titanium and aluminium alloy layer obtained is 9 $\mu$m.

The outer wear-resistant layer, consisting of titanium and aluminium alloy nitride, is sputtered with the following settings: $P_{Ar}$=2.0·10⁻³ mmHg; $P_N$=2.0·10⁻³ mmHg; $U_p$=800 V; $I_{Ti}$=50 A; $I_{Al}$=70 A; $I_{mag·Al}$=7A; $U_{mag·Al}$=400 V; which ensure that the layer is formed at the rate of 8 $\mu$m per hour, and the duration of the sputtering is 0.625 hours. The thickness of the titanium and aluminium alloy nitride layer obtained is 5 $\mu$m.

The renovated plunger with the sputtered wear-resistant two-layer coating and the shell of the same precision pair are fitted by grinding. The diameter $d_{res}$=17.014 mm of the renovated internal part of the precision pair, i.e. the plunger, is measured. The result is equal to the inner diameter $D_w$=17.014 mm of the external part of the precision pair, i.e. the shell.

**Claims**

1. Method for renovating steel precision pair parts which involves measuring the diameter of the internal part of the precision pair, measuring the inner diameter of the external part of the precision pair, determining the thickness of the two wear-resistant layer coatings to be sputtered on the internal part of the precision pair according to the difference between the measured diameters, sputtering the size-restoring layer of aluminium and titanium alloy with microhardness up to 10000 MPa on the internal part of the precision pair by means of ion plasma deposition, sputtering the outer wear-resistant layer of aluminium and titanium alloy nitride with microhardness exceeding 10000 MPa on the internal part of the precision pair by means of ion plasma deposition, and measuring the diameter of the renovated internal part of the precision pair, **characterized in that** the internal part of the precision pair is thermally annealed at a temperature of 400-600 °C and the oxidised layer is mechanically removed from the surface of the internal part of the precision pair before measuring the diameter of the internal part of the precision pair.

2. Method according to claim 1, wherein the thickness of the outer wear-resistant layer of titanium and aluminium alloy nitride with microhardness exceeding 10000 MPa is 2-5 $\mu$m, whereas the thickness of the size-restoring layer of titanium and aluminium alloy with microhardness up to 10000 MPa is such that it compensates the remaining wear of the internal part of the precision pair.

**Patentansprüche**

1. Verfahren zur Erneuerung der Präzisionspaardetaills, der aus rostfreiem Stahl hergestellt sind, umfassend die Messung des Durchmessers von innerem Detail des Präzisionspaars; die Messung des inneren Durchmessers von äusserem Präzisionspaardetail; die Abrechnung der Dicke der Zweischichtendeckung, die auf dem inneren Detail des Präzisionspaars zerstäubt soll, nach der Differez des gemessenen Durchmessers; das Sputtering der Erneuerungsschicht aus Titan- und Alluminiumlegierung mit Mikrofestigkeit bis 10000 MPa mit Hilfe von lonplasmamethode auf dem inneren Detail des Präzisionspaars; das Sputtering der äusseren Verschleissfestigkeitsschicht aus Titan - und Alluminiumlegierungnitrids mit Mikrofestigkeit über 10000 MPa mit der lonplasmamethode auf dem inneren Detail des Präzisionspaars; und die Messung des Durchmessers des inneren Details vom erneuerten Präzisionspaardetail, **dadurch gekennzeichnet, dass** vor der Messung des Durchmessers von innerem Detail des Präzisionspaars dieses innere Detail des Präzisionspaars bei 400-600 °C termisch bearbeitet wird und die Oberfläche des inneren Details des Präzisionspaars von oxydierter Schicht mechanisch gereinigt wird.

2. Verfahren nach Anspruch 1, **dadurch gekennzeichnet, dass** die Dicke der äusseren Verschleissfestigkeitsschicht aus Titan- und Alluminiumlegierungnitrids mit Mikrofestigkeit über 10000 MPa 2-5 Mikrometers ist, aber die Abmessung der Dicke von der Erneuerungsschicht der Titan-und Alluminiumlegierung mit Mikrofestigkeit bis 10000 MPa so hoch ist, dass sie den Verschleiss beim Präzisionspaar, wenn er vorkommt, kompensiert.

**Revendications**

1. Procédé de réparation d'une paire de pièces de précision en acier, qui comprend la mesure du diamètre de la partie interne de la paire de précision, la mesure du diamètre interne de la partie externe de la paire, la détermination de l'épaisseur de revêtement bi-couche résistant, qui devrait être pulvérisé sur la partie interne de la paire en fonction de la différence entre les diamètres mesurés, la pulvérisation cathodique de la couche de réstauration (alliage titane-aluminium) de microdureté jusqu'à 10.000 MPa sur la partie interne de la paire de précision au moyen de pulvérisation d'un plasma d'ions, la pulvérisation de la couche résistante à l'usure extérieure (alliage nitrure de titane-aluminium) de microdureté supérieure à 10 000 MPa sur la partie interne de la paire de précision au moyen de pulvérisation d'un plasma d'ions, en mesurant le diamètre de la partie interne rénové, **caractérisé en ce que** la partie interne de la paire de précision est thermiquement recuite à une température de 400-600 °C et que la couche oxydée est mécaniquement enlevée de la surface de la partie interne de la paire de précision avant de mesurer le diamètre de la partie interne.

2. Procédé selon la revendication 1, dans lequel l'épaisseur de la couche résistante à l'usure extérieure (alliage nitrure de titane-aluminium) de microdureté supérieure à 10 000 MPa est entre 2-5 mm, tandis que l'épaisseur de la couche de restauration (alliage titane-aluminium) de microdureté jusqu'à 10.000 MPa, est suffisante pour compenser l'usure restante de la partie interne de la paire de précision.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- RU 2242523
- CN 101413106

- LV 14057